# EUROPEAN PATENT APPLICATION

(11) **EP 4 512 677 A1**
(43) Date of publication of application: **26.02.2025**
(21) Application number: 24187707.5
(22) Date of filing: 10.07.2024
(51) Int. Cl.: B60W 30/00, G07C 5/00, G08G 1/16, H04W 4/029, H04W 4/40

(54) **METHOD FOR GENERATING DIGITAL TWIN, DIGITAL TWIN GENERATION PROGRAM, AND DIGITAL TWIN SEARCH METHOD**

(30) Priority: 25.08.2023 JP 2023137619
(71) Applicant: FUJITSU LIMITED, Kawasaki-shi, Kanagawa 211-8588 (JP)
(72) Inventor: KUNIKAWA, Masashi, Kawasaki-shi, Kanagawa, 211-8588 (JP); YOKOTA, Koichi, Slough, SL1 2BE (GB); NODA, Masahide, Kawasaki-shi, Kanagawa, 211-8588 (JP); KIHARA, Hideto, Kawasaki-shi, Kanagawa, 211-8588 (JP); GUO, Zhaogong, Kawasaki-shi, Kanagawa, 211-8588 (JP); IMAI, Tomoharu, Kawasaki-shi, Kanagawa, 211-8588 (JP)
(74) Representative: Hoffmann Eitle

(57) **Abstract**

A method for generating a digital twin in which a computer executes processing includes: aggregating a plurality of digital twins that is aggregatable and satisfies a specific condition, from among a plurality of digital twins and generating a single aggregated digital twin to which aggregation meaning is set; and giving a tag for identification to the generated aggregated digital twin.

## Description

### FIELD

The embodiment discussed herein is related to a method for generating a digital twin, a digital twin generation program, and a digital twin search method.

### BACKGROUND

A relation between a map of an object in a real world and the map can be expressed by a digital twin (DT). The DT is, for example, digital data obtained by sensing a value (property) indicating a characteristic such as a speed of the object and a relation (relationship) between the objects and converting the sensed values into data, using the object such as a road or an electric vehicle (EV) existing in the real world as a target.

The property and the relationship included in the digital twin such as the road or the EV vary with time. Therefore, a system for saving many digital twins has a time-series database (DB) in which changes are recorded at certain intervals. For example, the time-series DB included in a road traveling DT of the EV records time-series changes in a property for each traveled road, a traveling relationship of the EV on each road, and a property of the EV at the time of traveling, for each EV.

By using the DT, an influence and an effect of measures implemented in the past can be confirmed. To confirm the effect of the measures, it is possible to confirm a situation same as a situation in the real world, for example, it is possible to confirm a relation between values of properties and relationships of the plurality of digital twins by DT search, regarding the DT that affects the implemented measure.

As related art related to construction and the search of the DT, for example, there is one that performs object-correction on an exploratory eDT obtained by generating arbitrary clone cDTs from a source sDT and combining the clone cDTs with time increments and predicts evolution of a simulation result. Furthermore, there is one that calculates an estimated value of a pair of actions with the highest possibility from among a plurality of remote vehicles and specifies a collision risk of the own vehicle and the plurality of remote vehicles to be involved. Furthermore, there is one that responds a bus travel route to an incident and is dynamically updated by another twin of sDT/cDT, in the exploratory eDT obtained by generating the arbitrary clone cDTs from the source sDT and combining the clone cDTs. Furthermore, there is one that combines and manages each received target region under control between a plurality of systems, selects necessary information according to an object of the system, and distributes the selected information to the system to be constructed. Furthermore, there is one that acquires related information of an action performed by a target related to a waiting event and target information for evaluation, proposes an action plan so as to achieve the object according to each piece of the acquired information, and performs simulation for optimizing the event. Furthermore, there is a smart parking system, for searching for a DT associated with an individual, that detects a vehicle entering a parking, identifies the individual related to the vehicle, searches for context information corresponding to the individual, and determines a parking space based on the context information and the parking space. Furthermore, there is a logistics management system that optimizes an operation process of a sorting terminal, by constructing and verifying a DT that can simulate an operation of a logistics sorting terminal.

### [Citation List]

### [Patent Literature]

[PTL 1] Japanese Laid-open Patent Publication No. 2022-171571.
[PTL 2] Japanese Laid-open Patent Publication No. 2020-9428.
[PTL 3] Japanese Laid-open Patent Publication No. 2022-65622.
[PTL 4] Japanese Laid-open Patent Publication No. 2022-143830.
[PTL 5] Japanese Laid-open Patent Publication No. 2022-154775.
[PTL 6] U.S. Patent Application Publication No. 2020/0234590.
[PTL 7] U.S. Patent Application Publication No. 2022/0343260.

### Summary of Invention

### PROBLEMS

Since a DT maps an object in the real world, a large number of DTs are complicatedly related. An information amount of the DT and a search speed have a trade-off relationship. Therefore, in a case where a large number of DTs under a specific condition are searched, it takes a search time.

In one aspect, an object of the embodiment is to shorten a search time by optimizing a relationship between digital twins.

### Solution to Problem

According to an aspect of the embodiments, a method for generating a digital twin in which a computer executes processing includes: aggregating a plurality of digital twins that is aggregatable and satisfies a specific condition, from among a plurality of digital twins and generating a single aggregated digital twin to which aggregation meaning is set; and giving a tag for identification to the generated aggregated digital twin.

### EFFECTS OF INVENTION

According to one aspect, it is possible to shorten a search time by optimizing a relationship between digital twins.

### BRIEF DESCRIPTION OF DRAWINGS

FIG. 1 is a schematic explanatory diagram of a method for generating a digital twin according to an embodiment;
FIG. 2 is a diagram illustrating a specific example of a digital twin;
FIG. 3 is an explanatory diagram of time-series data of the digital twin;
FIG. 4 is an explanatory diagram of an example of generation and update processing of the digital twin in a digital twin system;
FIG. 5 is an explanatory diagram of an example of reading processing of the digital twin in the digital twin system;
FIG. 6 is an explanatory diagram of an example of search for measures by the digital twin;
FIG. 7 is an explanatory diagram of a search state of the digital twin based on a measure search condition;
FIG. 8 is an explanatory diagram of an example of search processing of the digital twin in the digital twin system;
FIG. 9A is an explanatory diagram of a relation between an information amount of the digital twin and a search time; (part 1)
FIG. 9B is an explanatory diagram of the relation between the information amount of the digital twin and the search time; (part 2)
FIG. 10A is an explanatory diagram of a cototwin obtained by integrating the plurality of digital twins according to the embodiment; (part 1)
FIG. 10B is an explanatory diagram of the cototwin obtained by integrating the plurality of digital twins according to the embodiment; (part 2)
FIG. 11A is an explanatory diagram illustrating a process of conversion into a cototwin and replacement of a relationship; (part 1)
FIG. 11B is an explanatory diagram illustrating the process of the conversion into the cototwin and the replacement of the relationship; (part 2)
FIG. 11C is an explanatory diagram illustrating the process of the conversion into the cototwin and the replacement of the relationship; (part 3)
FIG. 11D is an explanatory diagram illustrating the process of the conversion into the cototwin and the replacement of the relationship; (part 4)
FIG. 12 is a block diagram illustrating a functional configuration example of a digital twin system according to the embodiment;
FIG. 13 is a diagram illustrating a hardware configuration example of a digital twin generation device;
FIG. 14 is an explanatory diagram of a cototwin generation example according to the embodiment;
FIG. 15 is a sequence diagram of a cototwin generation example by implementing measures;
FIG. 16 is a flowchart illustrating an outline of cototwin generation processing;
FIG. 17 is a flowchart illustrating a detailed example of the cototwin generation processing;
FIG. 18 is an explanatory diagram of a digital twin search example according to the embodiment;
FIG. 19 is a sequence diagram of a digital twin search example at the time of implementing measures:
FIG. 20 is a flowchart illustrating a digital twin search processing example; and
FIG. 21 is an explanatory diagram of another application example of the conversion into the cototwin according to the embodiment.

### DESCRIPTION OF EMBODIMENTS

Hereinafter, embodiments of a method for generating a digital twin, a digital twin generation program, and a digital twin search method will be described in detail with reference to the drawings.

### (Embodiment of Method for Generating Digital Twin According to Embodiment)

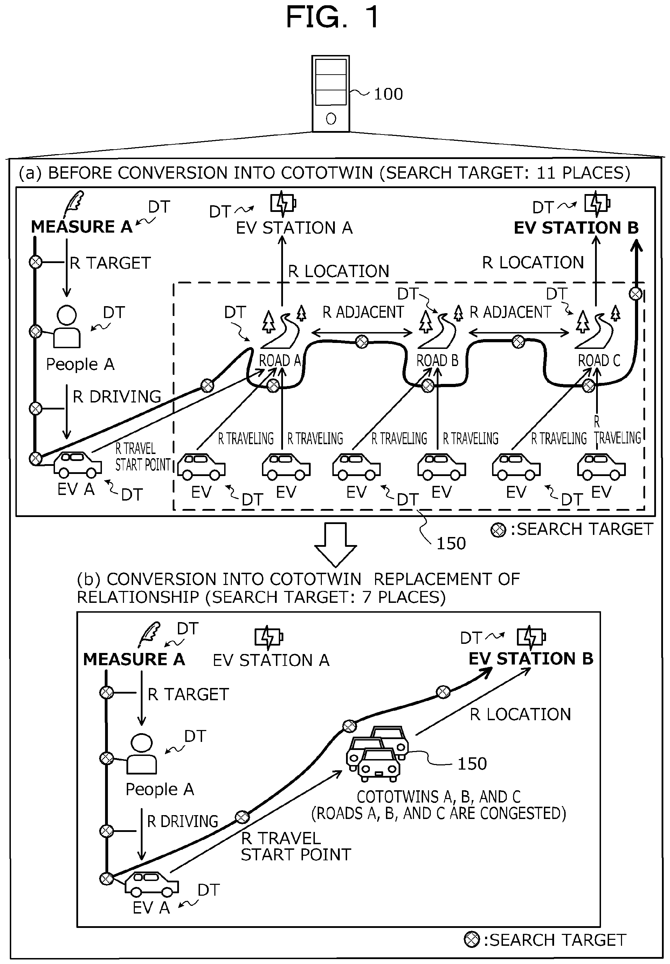

FIG. 1 is a schematic explanatory diagram of a method for generating a digital twin according to the embodiment. The method for generating a digital twin according to the embodiment shortens a search time, for example, by reducing the numbers of DTs and relationships, by optimizing a structure of a digital twin DT to be searched. In the optimization, information regarding a plurality of DTs that can be aggregated and satisfies a specific condition, among the plurality of DTs, is integrated (aggregated) into one, and an aggregated DT (referred to as cototwin) 150 to which meaning of the DT is set is generated.

The method for generating a digital twin according to the embodiment can be implemented by executing a program by a digital twin generation device 100 such as a server, and in addition, can be implemented by an access to a cloud. The digital twin generation device 100 according to the embodiment creates the cototwin 150 by the following processing.

Furthermore, in the embodiment to be described later, a digital twin search method will be described. For example, a digital twin search device performs search using the digital twin DT including the cototwin 150 generated by the digital twin generation device 100. In this case, a digital twin system including the digital twin generation device 100 and the digital twin search device can be implemented by using a single server or the like. In the following description, first, generation of the cototwin by the digital twin generation device 100 will be described.

The cototwin 150 has an aggregatable condition for conversion into a cototwin in a property so that a DT before being converted into the cototwin and the generated cototwin 150 have the same information as a search target. As a result, at the time when the DT is searched, the DT after being converted into the cototwin can obtain a search result similar to the DT before being converted into the cototwin.

FIG. 1(a) illustrates a DT structure before being converted into the cototwin (corresponding to related art), and FIG. 1(b) illustrates a DT structure after being converted into the cototwin according to the embodiment. In the method for generating a digital twin according to the embodiment, the cototwin 150 illustrated in FIG. 1(b) is generated from the normal DT structure illustrated in FIG. 1(a).

In FIG. 1, a DT search state based on a certain measure A is illustrated. For example, it is assumed that the measure A be "promoting use of EV station B", for a target who usually uses an EV station (charging station of electric vehicle EV) A. In order to confirm effects at the time when this measure A is implemented, in the DT search, a search for performing tracing based on relationships R of DTs of a plurality of roads before the vehicle EV reaches the EV station B, in relation to the measure A.

Each DT, that is, each of the measure A, a target (People A) who drives A, an EV A driven by the People A, a plurality of roads A, B, and C adjacent to each other, the EV, and the EV stations A and B has a property P and a relationship R. The road A is adjacent (coupled) to the road B, the road B is adjacent (coupled) to the road C, and the EV A reaches the EV station B via the roads A to C. In the following description, the plurality of relationships R may be distinguished by adding words such as a "driving" relationship or a "traveling" relationship.

Hereinafter, an outline of the conversion into the cototwin and the DT search will be described. Details of the conversion into the cototwin and the DT search will be described later. In the DT search, the EV A that is the driving relationship R in the same update time band as a target relationship R of the measure A is set as a search destination. Hereinafter, for the plurality of DTs, search is performed for tracing the DTs from a travel start point, the roads A to C, to the EV station as the search destination based on the relationship R. In FIGs. 1(a) and 1(b), an arrow (->) indicates the relationship R of each DT, and a thick line indicates a search route.

In the DT search before being converted into the cototwin (corresponding to related art) illustrated in FIG. 1(a), the number of DTs to be searched is 11. In FIG. 1(a), a circle indicates a search target, and 11 search targets in total, including the target, the People A, the EV A, each of the roads A to C, and the EV that has traveled each of the roads A to C are included.

Here, it is assumed that the roads A to C adjacent to each other be congested in common. In the embodiment, before the conversion into the cototwin, a meaning of "congestion" common to the adjacent roads A to C is given as the property P. Then, the number of traveling relationships of the vehicles EV that have traveled the respective roads A to C or the like is set as an aggregatable condition, and the plurality of DTs that satisfies the condition is integrated to generate the single cototwin 150.

As a result, in the embodiment, as illustrated in FIG. 1(b), the number of DTs (corresponding to search target) on the search route after the conversion into the cototwin is reduced as 11 -> 7. The relationships R of the 11 DTs illustrated in FIG. 1(a) are replaced (replaced) with relationships R of the seven DTs in total, on the search route illustrated in FIG. 1(b). Note that a range of the DTs included in the generated cototwin 150 illustrated in FIG. 1(b) is indicated by a dotted line in FIG. 1(a).

Due to the conversion into the cototwin, at the time of the DT search, the number of DTs to be searched and the number of relationships on the search route are reduced. Therefore, it is possible to shorten the search time. Since the cototwin 150 has information regarding each DT before being converted into the cototwin in the property, the cototwin 150 can have information same as that before the conversion into the cototwin and can secure a necessary information amount.

### (Problems of Related Art)

Here, the related art of the DT and problems thereof will be described.

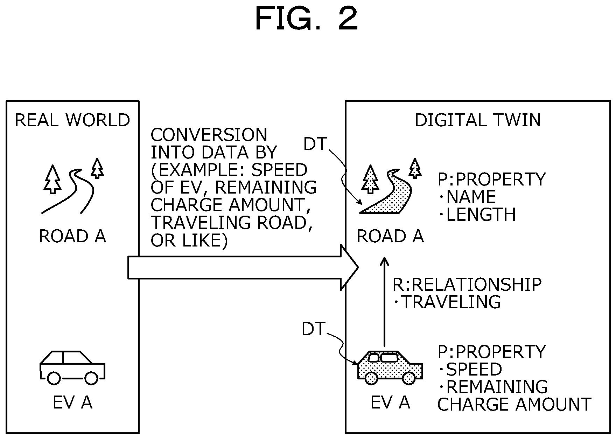

FIG. 2 is a diagram illustrating a specific example of the digital twin. In FIG. 2, digital twins (DT) of a road and an EV in a real world are illustrated. The DT is digital data obtained by sensing a value (property P) indicating a characteristic such as a speed of an object and a relation (relationship R) between the objects and converting the sensed values into data, using the object such as a road or an EV existing in the real world as a target.

In the example in FIG. 2, the DT converts a speed of the EV A traveling on the road A, a remaining charge amount, a traveling speed, or the like into data by sensing. In the DT, a property of the object "road A" includes a "name" and a "length" of the road A, and a property of the object "EV A" includes a "speed" and a "remaining charge amount" of the EV A. The relationship R between the objects "road A" and the "EV A" is "traveling".

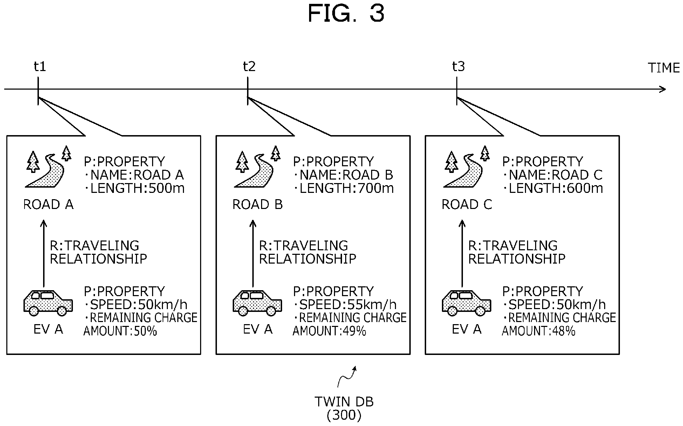

FIG. 3 is an explanatory diagram of time-series data of the digital twin. The time-series data of the DTs of the road and the EV described above will be described. The property P and the relationship R of the DT such as the road or the EV vary with time. Therefore, a twin database (DB) 300 included in the DT system is a time-series DB that records a change in data at each certain time in time series.

A horizontal axis illustrated in FIG. 3 is a time. In the example in FIG. 3, the twin DB 300 records a change in data in a case where the traveling relationship R of the EV A is switched as the road A → B → C.

In the example in FIG. 3, the twin DB 300 records the property P of the road on which the EV A has traveled at times t1 to t3, the property P of the EV A, and the relationship R between the road and the EV A, regarding the EV A. The property P of the road A traveled at the time t1 includes the "name: road A" and the "length: 500 m", and the property P of the EV A includes the "speed: 50 km/h" and the "remaining charge amount: 50%". Furthermore, the property P of the road B traveled at the time t2 includes the "name: road B" and the "length: 700 m", and the property P of the EV A includes the "speed: 55 km/h" and the "remaining charge amount: 49%". Furthermore, the property P of the road C traveled at the time t3 includes the "name: road C" and the "length: 600 m", and the property P of the EV A includes the "speed: 50 km/h" and the "remaining charge amount: 48 %". Note that, in FIG. 3, for convenience, only the roads having the relationship R with the EV A are illustrated. However, the roads A to C exist at any time (times t1 to t3).

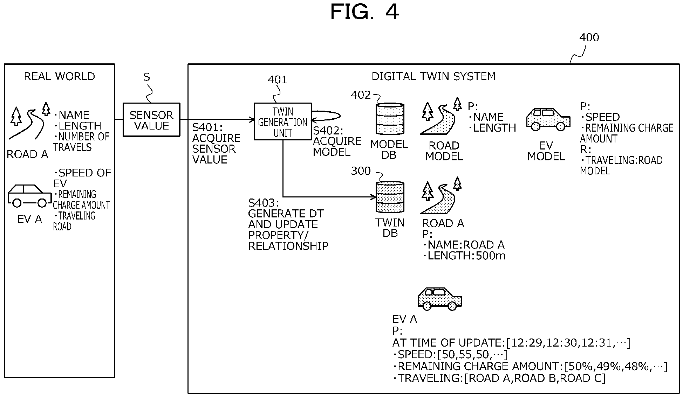

FIG. 4 is an explanatory diagram of an example of generation and update processing of the digital twin in the digital twin system. A digital twin system 400 includes a twin generation unit 401, a model DB 402, and the twin DB 300.

For example, the EV A in the real world collects various sensor values S of the roads and the EV A. In the example illustrated in FIG. 4, the sensor values are the property P of the road A and the property P of the EV A.

At the time when a new DT is created, the twin generation unit 401 acquires the sensor value S (step S401) and acquires a corresponding model from the model DB 402 (step S402). The model DB 402 includes a road model and an EV model. The road model and the EV model each include a property and a relationship. The twin generation unit 401 acquires a model only at the time when a new DT is created and does not acquire the model at the time of DT update.

Then, at the time when the new DT is created, the twin generation unit 401 generates a DT based on the acquired sensor value S and model and records the DT in the time-series twin DB 300 (step S403). The created DT includes the properties "name" and length" of the road A, the properties P "speed" and "remaining charge amount" of the EV A, and the traveling relationship R "roads A to C". Note that, since the value of the property P of the road A is a constant, the value does not have time-series data.

Furthermore, at the time of DT update due to the lapse of time, the twin generation unit 401 updates the created property of the road A, and the property P and the traveling relationship R of the EV A and further performs update including a property P "update time (12:29, 12:30, ...)" of the EV A.

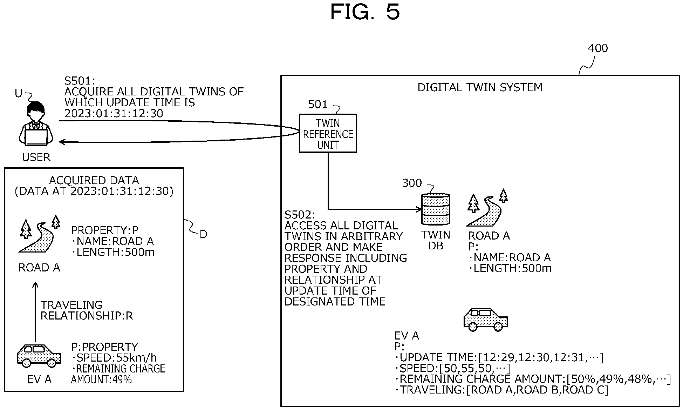

FIG. 5 is an explanatory diagram of an example of reading processing of the digital twin in the digital twin system. The digital twin system 400 includes a twin reference unit 501 that reads the created DT.

In the DT reading processing, for example, a user U requests acquisition of a DT of which an update time is designated (step S501). In the example in FIG. 5, it is assumed that the user U request acquisition of all the DTs at the time when the update time is 12: 30 on January 31 (date), 2023 (year) (step S501). In this case, the twin reference unit 501 in the digital twin system 400 refers to the twin DB 300, accesses all the DTs in an arbitrary order, and makes a response including the property P and the relationship R at the update time at the designated time (step S502).

At this time, the twin DB 300 responds the properties P "name" and "length" corresponding to the update time, regarding the road A. Note that, since the road A has a constant property value, the twin DB 300 constantly returns the same value. Furthermore, the twin DB 300 responds the properties P "update time", "speed", and "remaining charge amount" corresponding to the update time and the traveling relationship R, regarding the EV A.

As a result, the user U acquires data D corresponding to the update time requested by the digital twin system 400. In a case of the example in FIG. 5, the user U acquires the data D including the properties of the road A and the EV A and the traveling relationship R at the time when the update time is 12: 30 on January 31 (date), 2023 (year).

### (About Search of Digital Twin)

Next, search of the DT will be described. Confirmation as to whether or not a DT that affects effects of measures has the property P and relationship R same as a search condition, in order to confirm the effects of the measures implemented in the past, is referred to as the search of the DT.

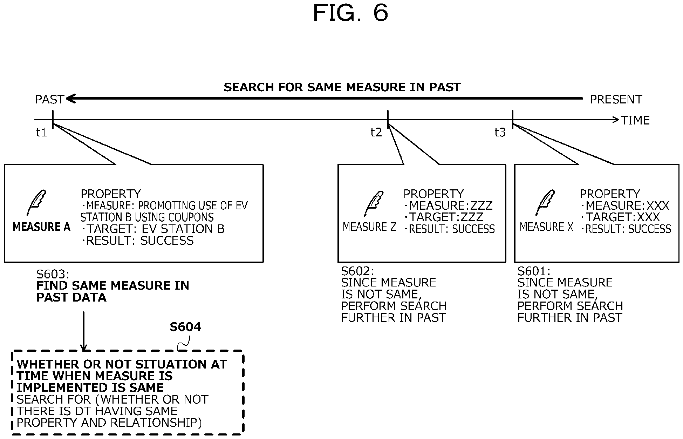

FIG. 6 is an explanatory diagram of an example of search for measures by the digital twin. The horizontal axis indicates a time from the past to the present, and indicates each measure at each time. An example of the search for measures in the past same as a certain measure will be described, with reference to FIG. 6. For example, it is assumed that the People A who drives the EV usually use the EV station A. It is assumed that a property P of the measure A includes measure: promoting use of the EV station B from the EV station A, target: the EV station B, and result: success. Note that the digital twin system 400 records the measure content, the target, and the result in the twin DB 300 as the properties, assuming the measure A itself as a measure A twin (DT).

At the time of implementing the measure A, the digital twin system 400 searches for whether or not the roads A, B, and C existing between the EV stations A and B, the EVs traveling on these roads A, B, and C, and a weather property P, and the relationship R therebetween match the search condition.

As illustrated in FIG. 6, in the search, the same measure as the measure A in past data is searched from the present to the past. Since a measure implemented at the time t3 is a measure X that is not the same measure as the measure A, the digital twin system 400 performs search further in the past (step S601). Next, since a measure implemented at the time t2 is a measure Z that is not the same measure as the measure A, the digital twin system 400 performs search further in the past (step S602).

Then, at the time t1, the digital twin system 400 finds the same measure A (step S603). However, since only content to the measure A is the same at this time, the digital twin system 400 needs to confirm whether or not the measure A is implemented in the same situation.

In the embodiment, search for "whether or not a situation at the time when the measure is implemented is the same" (step S604) is further performed. In step S604, the digital twin system 400 searches for whether or not there is a DT having a property P and a relationship R same as those in the situation in which the measure A is implemented, for example. Hereinafter, the search for "whether or not the situation at the time when the measure is implemented is the same" will be described.

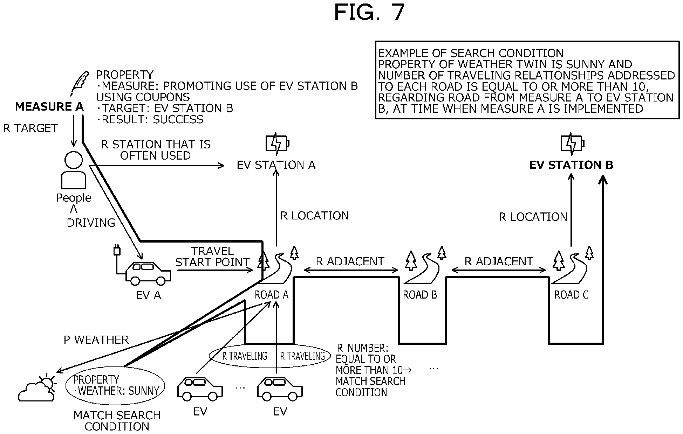

FIG. 7 is an explanatory diagram of a search state of the digital twin based on the search condition of the measure. In the example in FIG. 7, a search condition of the measure A is that the property P of the weather having the relationship R with the roads A, B, and C from the measure A to the EV station B is "sunny", at the time when the measure A is implemented. Furthermore, the number of traveling relationships R with the EV is "equal to or more than a certain number (equal to or more than 10)".

By using this search condition, regarding the measure A, in a case where all the roads A, B, and C have the sunny weather and are congested, it can be confirmed whether or not there has been an effect of implementing the measure A in the same situation in the past (all the roads A, B, and C have the sunny weather and are congested). The digital twin system 400 confirms whether the situation that affects the effect of the measure A is the same, according to the property P and the relationship R of the digital twin.

In FIG. 7, an arrow indicates (->) a relationship R of each DT, and a thick line indicates a search route. The property P of the measure A includes a measure "promoting use of the EV station B with coupons (such as discount)", a target "EV station B", and an effect "success".

In the DT search, the digital twin system 400 sets the measure A as a start point and traces the People A, the EV A, to the road A at a travel start point in order as a DT to be searched next. Here, if the weather of the property P of the road A is "sunny", it is determined that the property P matches the search condition. Furthermore, if the number of traveling relationships R of the property P of the road A is "equal to or more than 10 (corresponding to meaning of congestion caused by 10 or more EVs traveling on the road A in the same time band)", it is determined that this matches the search condition. In this way, if the property P of the road A is in the same situation as the measure A, the digital twin system 400 performs search, similarly to the road A, on the road B having the relationship R adjacent to the road A, in the next search. Hereinafter, similarly, search for tracing the relationship R to the EV station B is performed.

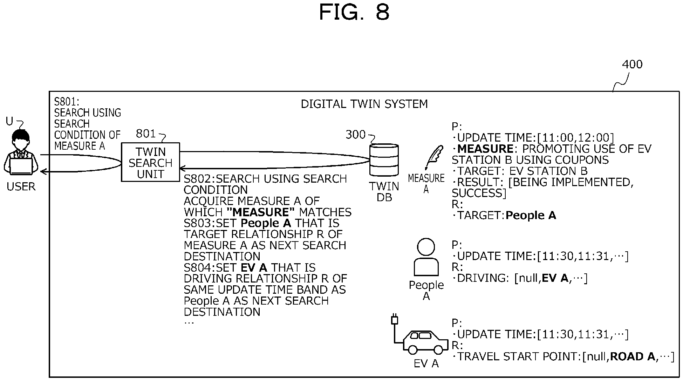

FIG. 8 is an explanatory diagram of an example of search processing of the digital twin in the digital twin system. The digital twin system 400 includes a twin search unit 801 that searches for a DT based on a search condition.

In the twin DB 300, a property P of the DT of the measure A includes an update time "11:00, 12:00", a measure "promoting use of the EV station B with coupons", a target "EV station B", and a result "being implemented, success". A relationship R of the measure A is a target "People A". Furthermore, a property of the DT of the People A includes an update time "11:30, 11:31, ...", and a driving relationship R is "null, EV A, ...".

Furthermore, it is assumed that a property P of the DT of the EV A be an update time "11:30, 11:31, ..." and a travel start point relationship be "null, road A, ...".

When DT search processing is described in correspondence with the description in FIG. 7, the user U performs search using a predetermined search condition corresponding to the measure A (step S801). The twin search unit 801 in the digital twin system 400 refers to the twin DB 300 and performs search using the search condition of the measure A. First, the twin search unit 801 acquires a DT of the measure A that matches the "measure" of the search condition (step S802).

Next, the twin search unit 801 sets the People A that is the target relationship R of the measure A as a next search destination (step S803). Next, the twin search unit 801 sets the EV A that is the driving relationship R in the same update time band as the People A as a next search destination (step S804). Thereafter, similar search is performed in the search order illustrated in FIG. 7.

### (About Information Amount of Digital Twin and Search Time)

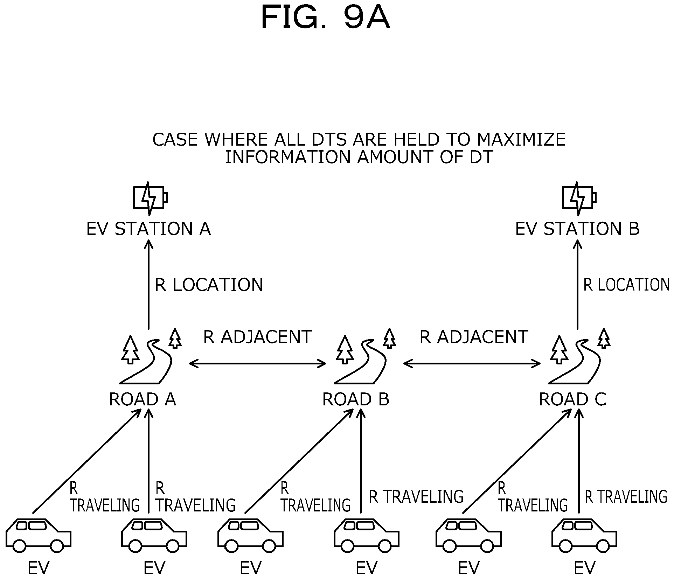

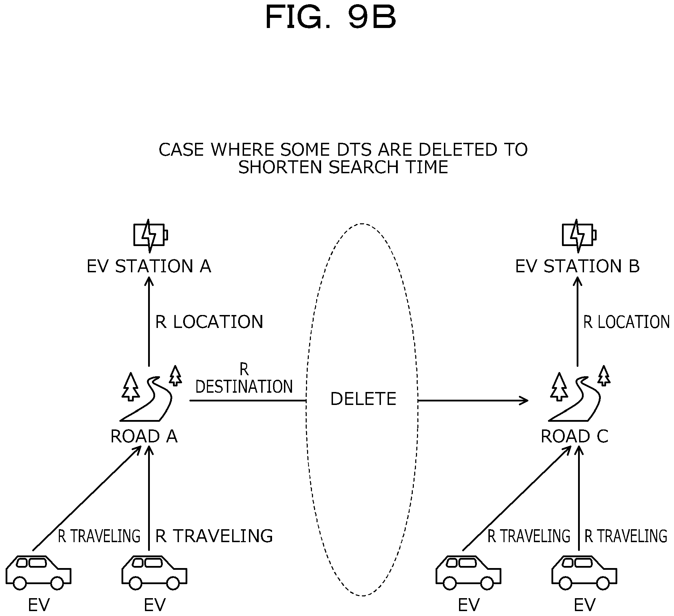

FIGs. 9A and 9B are explanatory diagrams of a relation between an information amount of the digital twin and a search time. At the time of design (construction) of the DT of the digital twin system 400, optimum design regarding a relation between DTs is performed within an assumed range.

In FIG. 9A, a case is illustrated where all the DTs are held in the twin DB 300 to maximize the information amount of the DT. On the other hand, in FIG. 9B, a case is illustrated where DTs of the road B and the EV or the like related to the road B are deleted from among the DTs in FIG. 9A.

The information amount held by the digital twin system 400 (twin DB 300) and a search speed has a trade-off relationship. For example, as in FIG. 9B, the property P and the relationship R of the DT confirmed at the time of search are reduced by an amount of the deletion of the road B or the like, and the search time can be shortened. On the other hand, since a DT necessary for verification of the effect of the measures at the time of operation or the like cannot be assumed at the time of design, optimal design in consideration of tradeoff is difficult.

For example, as in FIG. 9B, in a case where the DT related to the road B is deleted, the property P and the relationship R of the road B cannot be confirmed at the time of search, and it is not possible to confirm an effect including the road B, in a search result of the measure A. Note that, in a case where the DT of the road B is simply deleted, from among the roads A, B, and C having the adjacent relationship R adjacent to each other, a destination relationship R of the adjacent road A is unknown, and an original relationship R of the adjacent road C is also unknown. In the typical DT, since it is not possible to perform optimization in consideration of the above tradeoff at the time of design, it is not possible to obtain a necessary information amount while shortening the search time.

### (About Cototwin According to Embodiment)

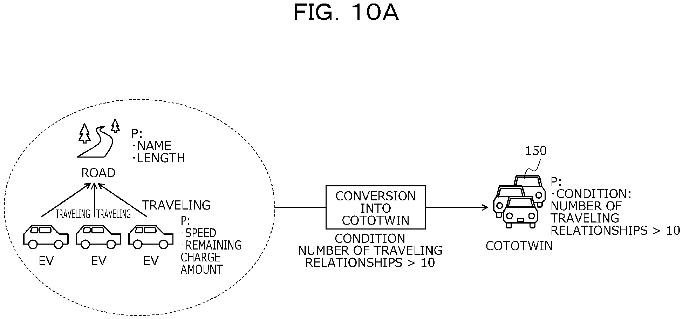

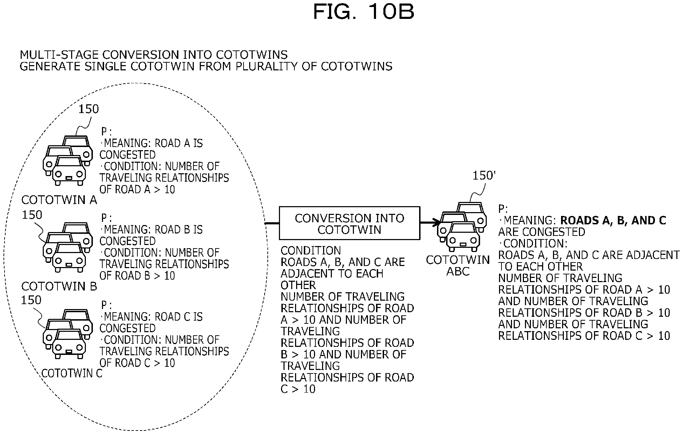

FIGs. 10A and 10B are explanatory diagrams of a cototwin obtained by integrating the plurality of digital twins according to the embodiment. In order to solve the above problems, the digital twin generation device 100 according to the embodiment generates a DT (cototwin) 150 in which the plurality of DTs is integrated based on a specific condition and meaning is given, and replaces the relationship R with respect to the generated cototwin 150. As a result, the number of DTs to be confirmed at the time of search can be reduced, and the search speed can be improved.

The cototwin 150 has meaning and conditions as the property P. By having the condition in the property P of the cototwin 150, a life cycle of the cototwin 150 can be managed. Furthermore, a DT before being converted into the cototwin and the DT (cototwin 150) after being converted into the cototwin have the same information as a search target.

In the example illustrated in FIG. 10A, the plurality of DTs "EV" is coupled to the DT "road" before the cototwin is generated, with the traveling relationship R. It is assumed that the property P of the road include "name" and "length" and the property P of each EV include "speed" and "remaining charge amount".

The digital twin generation device 100 sets "the number of traveling relationships > 10" as a cototwin conversion condition. The digital twin generation device 100 sets the condition "the number of traveling relationships > 10", to a property P of the generated cototwin 150. This condition is based on that the number of traveling EVs on a certain road in the same time band is more than 10 = meaning "road congestion".

In FIG. 10B, multi-stage conversion into cototwins is illustrated. The digital twin generation device 100 can generate a single cototwin 150' from the plurality of cototwins 150 generated according to FIG. 10A.

For example, it is assumed that three cototwins A, B, and C (150) be generated for the respective roads A, B, and C illustrated in FIG. 10B. A property P of the generated cototwin A (150) includes meaning "road A is congested" and a condition "the number of traveling relationships of road A > 10". A property P of the generated cototwin B (150) includes meaning "road B is congested" and a condition "the number of traveling relationships of road B > 10". A property P of the generated cototwin C (150) includes meaning "road C is congested" and a condition "the number of traveling relationships of road C > 10".

The digital twin generation device 100 generates the single cototwin 150' from the three cototwins A, B, and C (150), based on the multistage condition and the condition of each of the cototwins A, B, and C. For example, the multistage condition is "the roads A, B, and C are adjacent to each other". Furthermore, the conditions of the respective cototwins A, B, and C are "the number of traveling relationships of road A > 10, the number of traveling relationships of road B > 10, and the number of traveling relationships of road C > 10".

The digital twin generation device 100 generates the single cototwin 150' from the cototwins A, B, and C (150) that satisfy both of the multistage condition and the condition of each of the cototwins A, B, and C. The cototwin 150' generated by multi-stage conversion into the cototwin is obtained by integrating the DTs related to the adjacent roads A, B, and C into the single DT. A property P of the cototwin 150' includes meaning "roads A, B, and C are congested" and a condition "the number of traveling relationships of road A > 10, the number of traveling relationships of road B > 10, and the number of traveling relationships of road C > 10". The meaning of the cototwin 150' is obtained by aggregating (integrating) meanings of "congestion of road A", "congestion of road B", and "congestion of road C" of the respective original cototwins 150 as "congestion of roads A, B, and C".

### (Conversion into Cototwin and Replacement of Relationship)

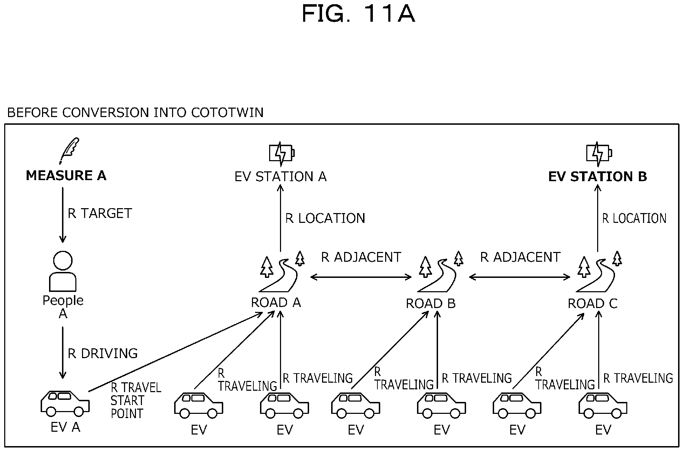

Each of FIGs. 11A to 11D is an explanatory diagram illustrating a process of conversion into a cototwin and replacement of a relationship. FIGs. 11A to 11D correspond to details of the processing in FIGs. 1(a) and 1(b). FIG. 11A illustrates a state before being converted into the cototwin, an in FIG. 1(a), each of the measure A, the EV A, the People A, the roads A, B, and C, the EV, and the EV stations A and B includes the property P and the relationship R, as the plurality of DTs.

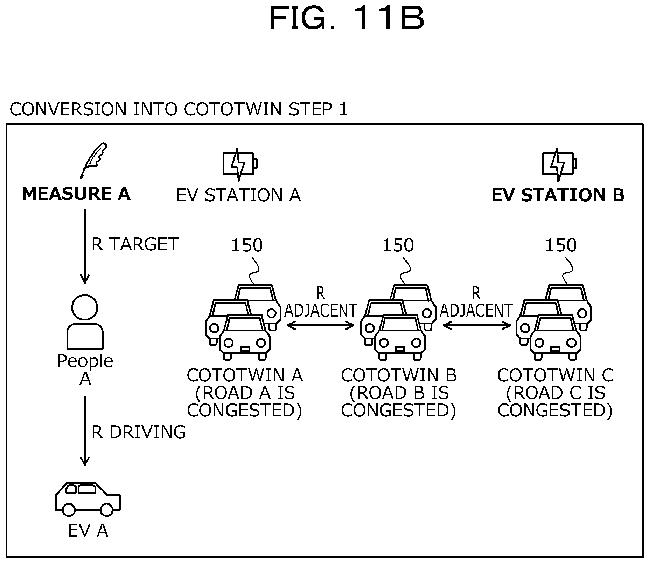

In a conversion-into-cototwin STEP 1 illustrated in FIG. 11B, the digital twin generation device 100 integrates the plurality of DTs related to each other for each of the roads A to C and applies meaning, by the conversion into the cototwin described above. The cototwin A (150) is obtained by integrating the DT related to the road A, that is, the road A and the DT of the EV that has traveled on the road A into one. The cototwin B (150) is obtained by integrating the road B and the DT of the EV that has traveled on the road B as one. The cototwin C (150) is obtained by integrating the road C and the DT of the EV that has traveled on the road C as one. Each of the cototwins A, B, and C (150) includes meaning "road X is congested (X = A, B, C)" in the property P.

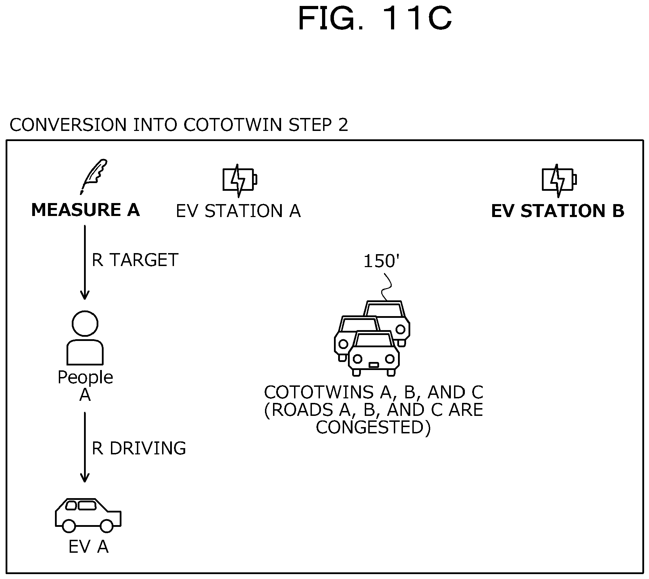

In a conversion-into-cototwin STEP 2 illustrated in FIG. 11C, the digital twin generation device 100 performs multi-stage conversion into the cototwin and generates the cototwin 150' in which the three cototwins A, B, and C (150) are integrated and the meaning is applied. The cototwin ABC (150') includes the meaning "roads A, B, and C are congested" in the property P.

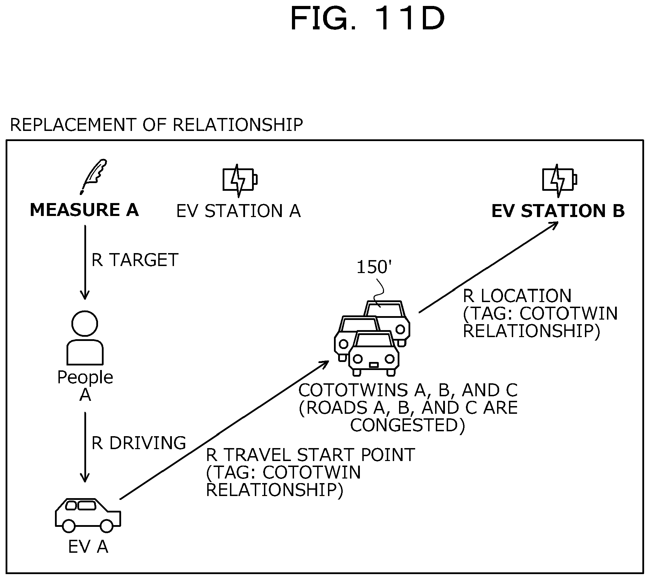

In the reapplication of the relationship illustrated in FIG. 11D, the digital twin generation device 100 replaces the relationship with the relationship R of the generated cototwin ABC (150'). Due to the replacement, the relationship R of the cototwin ABC (150') includes only a relationship R "travel start point" with the EV A and a relationship R "location" with the EV station B.

The digital twin generation device 100 generates the cototwin 150' as a cototwin and gives information that enables identification from the DT, for example, a tag "cototwin relationship" to the relationship R of the cototwin 150'.

The generation of the cototwin 150' illustrated in FIG. 11D and the replacement of the relationship with respect to the generated cototwin 150' can reduce the number of DTs to be searched and the number of relationships thereof, as in FIG. 1(b), and the search time can be shortened. Note that the cototwin 150 in FIG. 1(b) corresponds to the cototwin 150' after the multi-stage conversion into the cototwin in FIG. 11D.

In the above description, the digital twin generation device 100 does not delete and keeps the plurality of original DTs related to each of the roads A, B, and C to be converted into the cototwin, after the conversion into the cototwin. Then, in a case where the generated cototwin 150' exists by referring to the tag of the cototwin 150' at the time of DT search, the digital twin generation device 100 searches for the generated cototwin 150' in priority to the original DTs. At the time of preferential search for the cototwin 150', the original DT does not affect the search processing.

### (Functional Configuration Example of Digital Twin System)

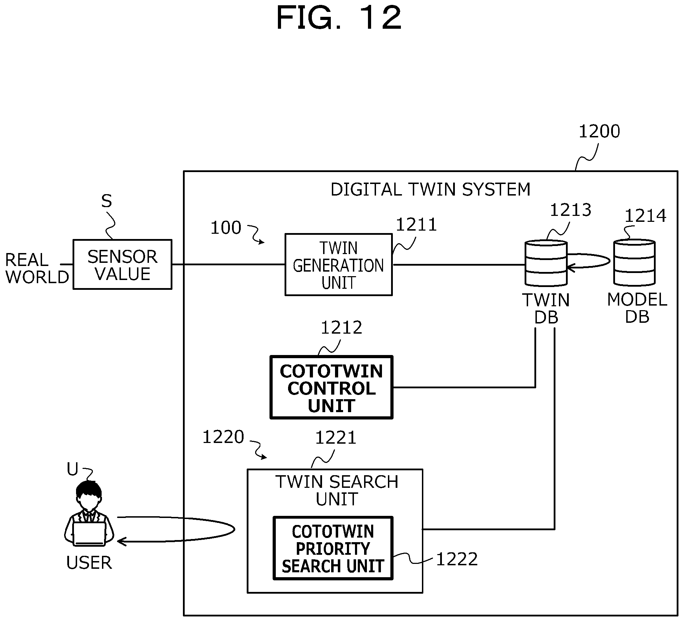

FIG. 12 is a block diagram of a functional configuration example of the digital twin system according to the embodiment. A digital twin system 1200 has functions of the digital twin generation device 100 that generates the DT described above and functions of a digital twin search device 1220 using the generated DT. In the embodiment, in addition to typical components illustrated in FIG. 12, components indicated by thick frames (thick characters) are included.

The digital twin generation device 100 side includes a twin generation unit 1211, a cototwin control unit 1212, a twin DB 1213, and a model DB 1214.

The twin generation unit 1211 is a typical function similarly to the twin generation unit 401 in FIG. 4. The twin generation unit 1211 acquires a sensor value S from a target in a real world and generates a DT from the acquired sensor value S. The twin generation unit 1211 generates the DT with reference to a model recorded in the model DB 1214 and records the DT in the twin DB 1213. The DT has a property P and a relationship R. Here, the twin generation unit 1211 generates time-series DTs of which the property P and the relationship R are updated in correspondence with the lapse of time (refer to FIG. 3).

In the embodiment, the digital twin generation device 100 further has a function of the cototwin control unit 1212. The cototwin control unit 1212 monitors the twin DB 1213 and generates a single cototwin 150 from the plurality of DTs that satisfies a generation condition. The cototwin control unit 1212 records the generated cototwin 150 in the twin DB 1213.

The digital twin search device 1220 side includes a twin search unit 1221. The twin search unit 1221 has a function of a cototwin priority search unit 1222.

The twin search unit 1221 performs search using a search condition corresponding to a predetermined measure (measure A) by the user U, with the typical function, similarly to the twin search unit 801 in FIG. 8. At the time of this search, the twin search unit 1221 refers to the twin DB 402, acquires a DT that matches the "measure A" that is the search condition, performs search for tracing the relationship R between the DTs, and returns a search result to the user U (refer to FIG. 1(a) and FIG. 7).

In the embodiment, the function of the cototwin priority search unit 1222 is included in the twin search unit 1221. In a case where the cototwin 150 created by the cototwin control unit 1212 is in the twin DB 1213, the cototwin priority search unit 1222 switches to search based on the property P and the relationship R indicated by the cototwin 150 (150') (refer to FIG. 1(b)). Here, the cototwin priority search unit 1222 preferentially performs the search based on the relationship R of the created cototwin 150, than the search based on the relationship R of the plurality of original DTs before the cototwin creation. The cototwin priority search unit 1222 determines whether or not the cototwin 150 exists based on the description on the above tag.

As a result, although the twin search unit 1221 returns the search result similar to the typical one, to the user U, the number of DTs (the number of relationships) to be searched is reduced by using the cototwin 150, and the search time can be shortened.

### (Hardware Configuration Example of Digital Twin Generation Device)

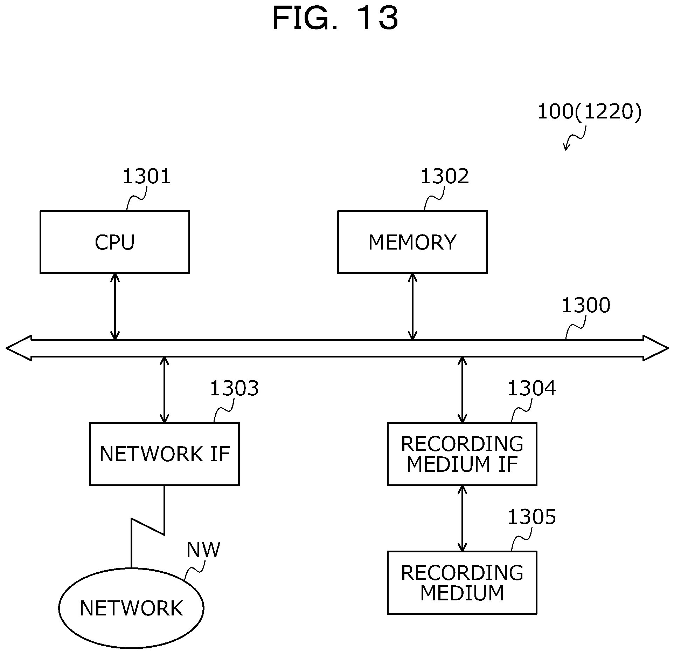

FIG. 13 is a diagram illustrating a hardware configuration example of the digital twin generation device. In FIG. 13, as the digital twin generation device 100, a general-purpose server can be used. The digital twin generation device 100 includes a central processing unit (CPU) 1301 such as a processor, a memory 1302, a network interface (IF) 1303, a recording medium IF 1304, and a recording medium 1305. Furthermore, each component is coupled by a bus 1300.

Here, the CPU 1301 is a control unit that controls the entire digital twin generation device 100. The CPU 1301 may include a plurality of cores. The memory 1302 includes, for example, a read only memory (ROM), a random access memory (RAM),
a flash ROM, or the like. Specifically, for example, the flash ROM stores an operating system (OS) program, the ROM stores application programs, and the RAM is used as a work area for the CPU 1301. The programs stored in the memory 1302 are loaded into the CPU 1301, to cause the CPU 1301 to execute coded processing.

The network IF 1303 is coupled to a network NW through a communication line, and can be coupled to an external computer through the network NW. Then, the network IF 1303 manages an interface between the network NW and the inside of the device, and controls input and output of data from the external computer. For example, a modem, a local area network (LAN) adapter, or the like may be adopted as the network IF 1303.

The recording medium IF 1304 controls reading/writing of data from/to the recording medium 1305 under control of the CPU 1301. The recording medium 1305 stores written data. Examples of the recording medium 1305 include a magnetic disk such as a hard disk drive (HDD), an optical disk, a solid state drive (SSD), a universal serial bus (USB) memory, or the like.

Note that the digital twin generation device 100 may include, for example, an input device, a display, or the like, in addition to the components described above.

Each function of the digital twin generation device 100 illustrated in FIG. 12 can be implemented by executing the program by the CPU 1301 illustrated in FIG. 13. Each data in a storage unit (twin DB 1213 and model DB 1214) illustrated in FIG. 12 can be stored using the memory 1302 and the recording medium 1305 illustrated in FIG. 13.

Furthermore, the digital twin search device 1220 illustrated in FIG. 12 can be also implemented by using the hardware configuration in FIG. 13. In addition, the digital twin system 1200 including both of the digital twin generation device 100 and the digital twin search device 1220 illustrated in FIG. 12 can be implemented by using the hardware configuration in FIG. 13.

### (Cototwin Generation Processing Example According to Embodiment)

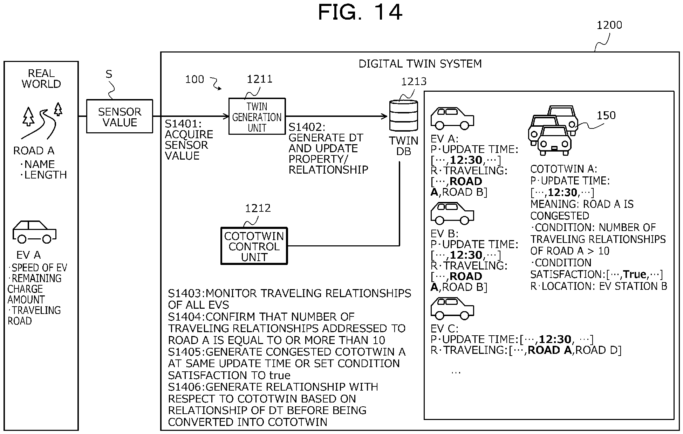

FIG. 14 is an explanatory diagram of a cototwin generation example according to the embodiment. In FIG. 14, the digital twin generation device 100 in the digital twin system 1200 is illustrated, and a specific example for generating the cototwin 150 from the DT described with reference to FIGs. 11A to 11D will be described.

The twin generation unit 1211 acquires the sensor value S from the DT target (EV or the like) in the real world (step S1401). The twin generation unit 1211 generates times-series DT of which the property P and the relationship R are updated, according to the sensor value S for each lapse of time and records the DT in the twin DB 1213 (step S1402).

The cototwin control unit 1212 monitors the traveling relationships R of all the EVs, among the DTs in the twin DB 1213 (step S1403). Then, the cototwin control unit 1212 confirms that the number of traveling relationships addressed to the road A is equal to or more than 10 (step S1404). Next, the cototwin control unit 1212 generates the congested cototwin A at the same update time (for example, 12:30) (step S1405). Then, the cototwin control unit 1212 generates the relationship R with respect to the cototwin based on the relationship R of the DT before being converted into the cototwin (step S1406).

In the above processing, for example, regarding the DT of each EV, the EV A includes the traveling relationship R "road A" at the update time "12:30" in the property P. Furthermore, the EV B includes the traveling relationship R "road A" at the update time "12:30" in the property P. Furthermore, the EV C includes the traveling relationship R "road A" at the update time "12:30" in the property P.

The cototwin control unit 1212 generates a single cototwin A from the three DTs (EV A to C) including the condition of the conversion into the cototwin "the number of traveling relationships R of road A > 10", the same update time "12:30", and the traveling relationship R "road A". A property P of the cototwin A includes an update time "12:30", meaning "road A is congested", a condition "the number of traveling relationships of road A > 10", and a satisfaction condition "True". Furthermore, the traveling relationship R includes "location: EV station B".

Note that the condition satisfaction indicates a value indicating when the cototwin exists (does not exist at the time of false), as the time-series data. Therefore, in cototwin deletion processing, the condition satisfaction of the cototwin is set as false and the cototwin is assumed not to currently exist (however, is not deleted from time-series data). On the other hand, in initial cototwin generation processing, a model is acquired and a DT is generated (condition satisfaction is True, as initial value), and in subsequent processing, the condition satisfaction is set to True at the time of update.

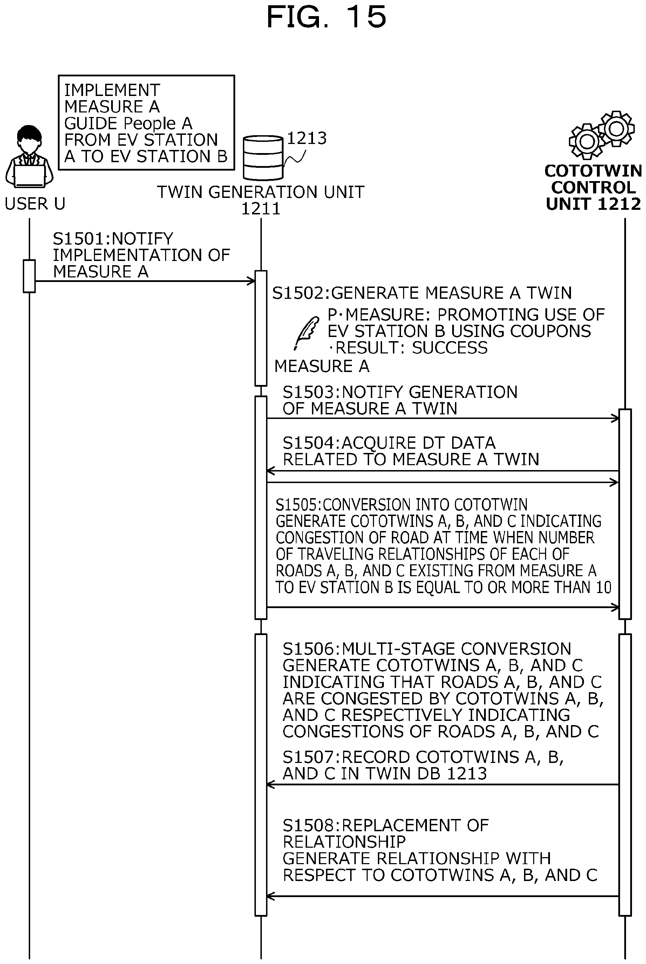

FIG. 15 is a sequence diagram of a cototwin generation example by implementing measures. In FIG. 15, interactions between the user U, the twin generation unit 1211 (twin DB 1213) in the digital twin generation device 100, and the cototwin control unit 1212 regarding the cototwin generation are illustrated.

First, implementation of the measure A planned by the user U is notified to the digital twin generation device 100 (step S1501). It is assumed that the measure A of the user U be "guide driver (People A) of EV A from EV station A to EV station B". Upon receiving this notification, the twin generation unit 1211 generates the measure A twin (step S1502, refer to FIG. 11A). The property P of the measure A is "measure: promoting use of EV station B with coupons", and the result is "success". The twin generation unit 1211 notifies the cototwin control unit 1212 of the generation of the measure A twin (step S1503).

Next, the cototwin control unit 1212 acquires DT data related to the measure A twin from the twin DB 1213 (step S1504) and executes processing of the conversion into the cototwin (step S1505). At this time, the cototwin control unit 1212 generates the three cototwins A, B, and C (150) indicating the congestion of the road, when the number of traveling relationships of each of the DTs of the roads A to C existing between the DT of the measure A and the EV station B is equal to or more than 10 (refer to FIG. 11B).

Next, the cototwin control unit 1212 executes multi-stage cototwin conversion processing (step S1506). At this time, the cototwin control unit 1212 generates the single cototwin ABC (150') indicating that the roads A to C are congested, by the three cototwins A, B, and C (150) respectively indicating the congestions of the roads A to C (refer to FIG. 11C). Then, the cototwin control unit 1212 records the generated cototwin ABC (150') in the twin DB 1213 (step S1507).

Next, the cototwin control unit 1212 replaces the relationship (step S1508). At this time, the cototwin control unit 1212 generates the relationship R for the cototwin ABC (150').

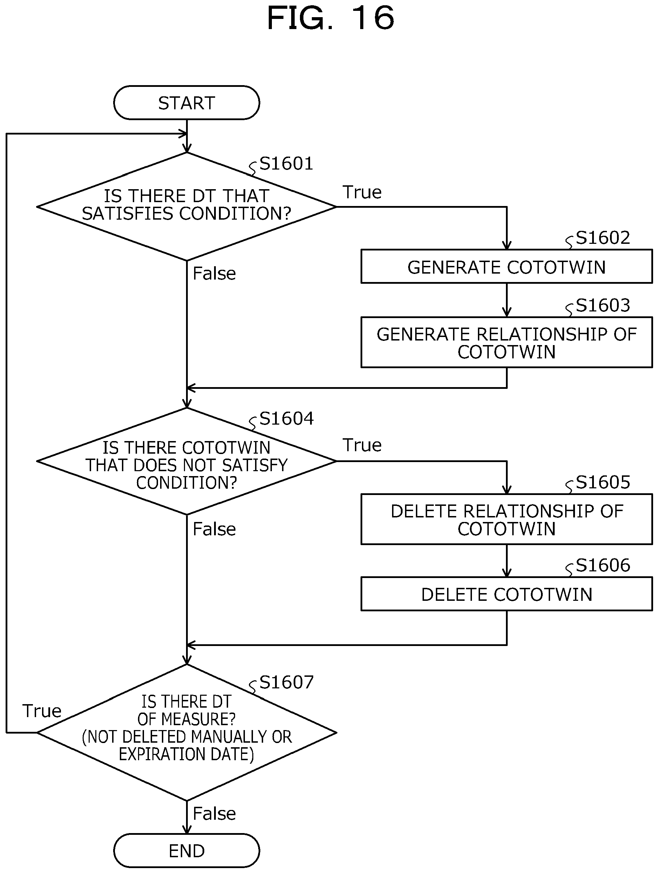

FIG. 16 is a flowchart illustrating an outline of cototwin generation processing. The processing illustrated in FIG. 16 indicates processing related to life cycle management of the cototwin by cototwin control, by executing a program by the control unit (CPU 1301) of the digital twin generation device 100.

The digital twin generation device 100 executes the following processing, based on a measure DT corresponding to the measure of the user U. First, the digital twin generation device 100 determines whether or not a DT that satisfies a measure condition exists (step S1601). If there is the DT that satisfies the measure condition (step S1601: True), the digital twin generation device 100 generates a cototwin (step S1602). Furthermore, the digital twin generation device 100 generates a relationship R of the generated cototwin (step S1603) and proceeds to processing in step S1604.

If there is no DT that satisfies the measure condition (step S1601: False) in step S1601, the digital twin generation device 100 proceeds to processing in step S1604. In step S1604, the digital twin generation device 100 determines whether or not there is a cototwin that does not satisfy the condition (step S1604).

In a case where there is the cototwin that does not satisfy the condition (step S1604: True), the digital twin generation device 100 deletes the corresponding relationship R of the cototwin (step S1605). Furthermore, the digital twin generation device 100 deletes this cototwin (step S1606) and proceeds to processing in step S1607.

If there is no cototwin that does not satisfy the condition in step S1604 (step S1604: False), the digital twin generation device 100 proceeds to processing in step S1607.

In step S1607, the digital twin generation device 100 determines whether or not there is the DT of the measure (step S1607). For example, if the DT of the measure is not deleted manually by the user U or on a predetermined expiration date, the DT of the measure exists. If there is the DT of the measure in step S1607 (step S1607: True), the digital twin generation device 100 returns to the processing in step S1601. On the other hand, if there is no DT of the measure (step S1607: False), the digital twin generation device 100 ends the above processing.

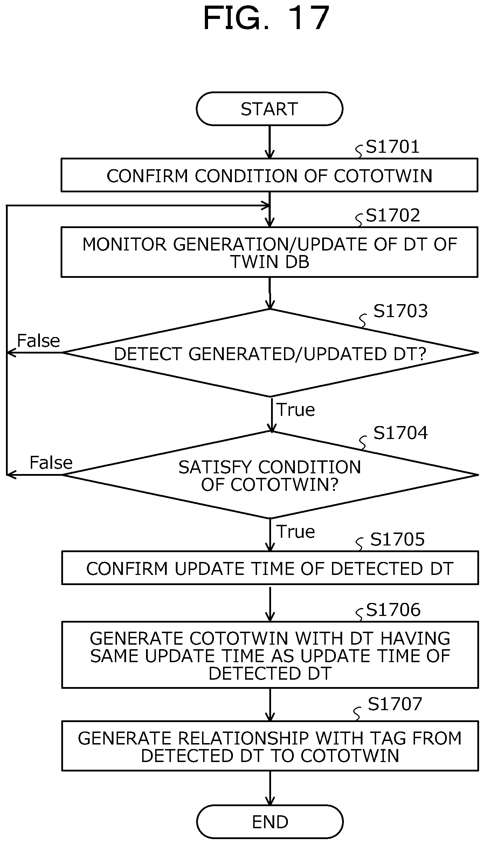

FIG. 17 is a flowchart illustrating a detailed example of the cototwin generation processing. Processing in FIG. 17 indicates details corresponding to steps S1601 to S1603 in FIG. 16.

First, the digital twin generation device 100 confirms a condition of the cototwin (step S1701). Next, the digital twin generation device 100 monitors generation and update of the DT in the twin DB 1213 (step S1702).

Next, the digital twin generation device 100 determines whether or not the generated or updated DT is detected (step S1703). If the generated or updated DT is detected (step S1703: True), the digital twin generation device 100 proceeds to processing in step S1704. On the other hand, if the generated or updated DT is not detected (step S1703: False), the digital twin generation device 100 returns to the processing in step S1702.

In step S1704, the digital twin generation device 100 determines whether or not the detected or updated DT satisfies the condition of the cototwin (step S1704). In a case where the detected or updated DT satisfies the condition of the cototwin (step S1704: True), the digital twin generation device 100 proceeds to processing in step S1705. On the other hand, in a case where the detected or updated DT does not satisfy the condition of the cototwin (step S1704: False), the digital twin generation device 100 returns to the processing in step S1702.

In step S1705, the digital twin generation device 100 confirms an update time of the detected DT (step S1705). Next, the digital twin generation device 100 generates the cototwin with the DT having the same update time as the update time of the detected DT (step S1706). Thereafter, the digital twin generation device 100 generates a relationship R with a tag from the detected DT to the cototwin (step S1707) and ends the above processing. The tag represents the relationship R to the cototwin.

### (Digital Twin Search Processing Example According to Embodiment)

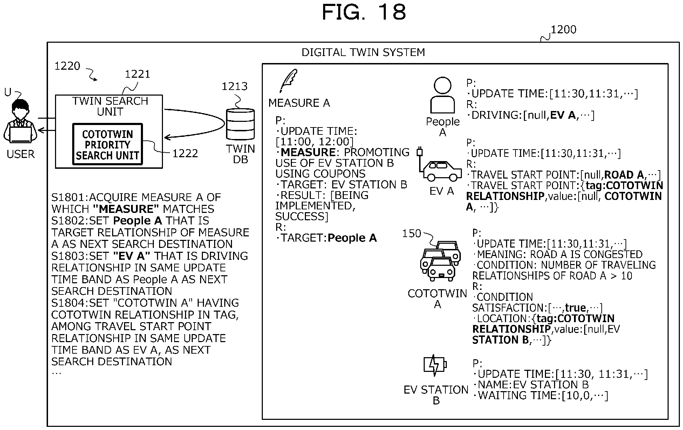

FIG. 18 is an explanatory diagram of a digital twin search example according to the embodiment. In FIG. 18, the digital twin search device 1220 in the digital twin system 1200 is illustrated. A specific example for searching for a DT including a cototwin will be described.

The twin search unit 1221 refers to the twin DB 1213 and acquires a DT of the measure A that matches "measure" of a search condition of the user U (step S1801). Next, the twin search unit 801 sets the People A that is the target relationship R of the measure A as a next search destination (step S1802). Next, the twin search unit 801 sets the EV A that is the driving relationship R in the same update time band as the People A as a next search destination (step S1803).

Here, the cototwin priority search unit 1222 of the twin search unit 1221 sets the cototwin A having the cototwin relationship R in the tag, among the travel start point relationship R in the same update time as the EV A, as a next search destination (step S1804). Here, the cototwin priority search unit 1222 sets the cototwin A (150) having the cototwin relationship R in the tag, in priority to the DT (EV) with the relationship R that does not have the tag in the travel start point relationship R in the same update time band as the EV A, as a next search destination. In this way, the cototwin priority search unit 1222 determines the next search destination based on whether or not the tag is given and preferentially sets the cototwin having the tag as the search destination.

In the above processing, for example, for each DT, the measure A includes the measure "promoting use of EV station B with coupons" in the property P and the target "People A" in the relationship R.

The People A includes driving "EV A" in the relationship R. The EV A includes the travel start point "road A" in the relationship R, "tag (tag): cototwin relationship", and "cototwin A" in the value. The cototwin A (150) includes the condition satisfaction "true" in the relationship R, "tag (tag): cototwin relationship" in the location, and "EV station B" in the value.

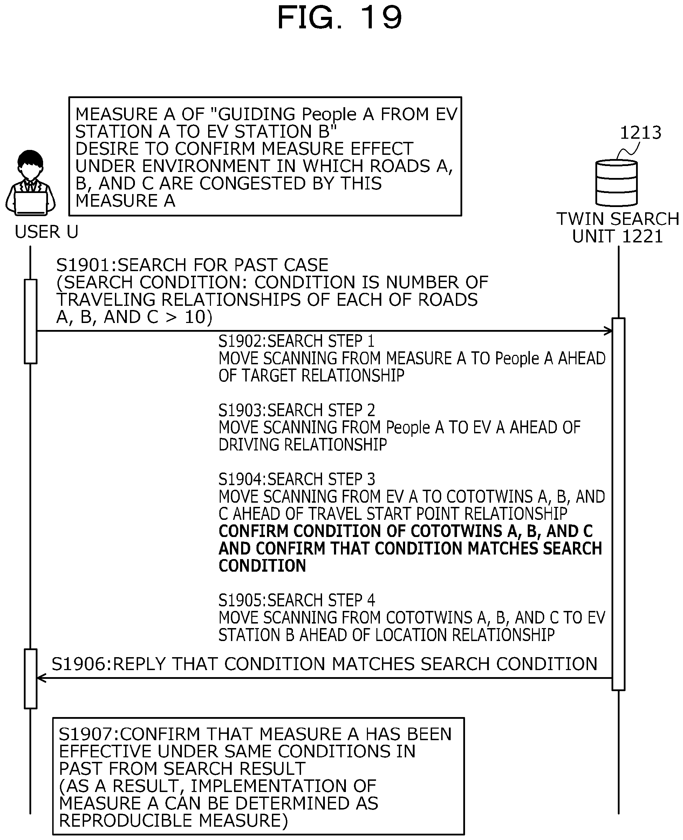

FIG. 19 is a sequence diagram of the digital twin search example at the time of implementing the measures. In FIG. 19, interactions between the user U related to the DT search including the cototwin and the twin search unit 1221 (twin DB 1213) in the digital twin search device 1220 are illustrated.

It is assumed that a measure that the user U desires to search be the measure A "for guiding the driver (People A) of the EV A from the EV station A to the EV station B". It is assumed that the user U has a purpose of confirming a measure effect under an environment in which the roads A to C are congested, by this measure A.

The user U accesses the digital twin search device 1220 and searches for a past case corresponding to the measure (step S1901). The search condition is "condition is the number of traveling relationship of each of roads A to C > 10".

The digital twin search device 1220 (twin search unit 1221) moves scanning of the search from the measure A to the People A ahead of the target relationship R, as a search STEP1 (step S1902). Next, the twin search unit 1221 moves scanning from the People A to the EV A ahead of the driving relationship R, as a search STEP2 (step S1903).

Next, the twin search unit 1221 moves scanning from the EV A to the cototwin ABC (150) ahead of the travel start point relationship R, as a search STEP3 (step S1904). In this search STEP3, the cototwin priority search unit 1222 in the twin search unit 1221 functions, and search for the cototwin ABC (150)) is in priority to the DT.

Next, the twin search unit 1221 moves scanning from the cototwin ABC (150) to the EV station B ahead of the location relationship R, as a search STEP4 (step S1905). Furthermore, the twin search unit 1221 confirms the condition of the cototwin ABC (150) and confirms that the condition matches the search condition. Thereafter, the twin search unit 1221 replies to the user U that the condition matches the search condition (step S1906).

As a result, the user U confirms that the measure A has been effective under the same conditions in the past from the search result (step S1907). The user can determine implementation of the measure A as a reproducible measure, from this result. The search state of the DT including the cototwin 150 described above corresponds to FIG. 11D and FIG. 1(b).

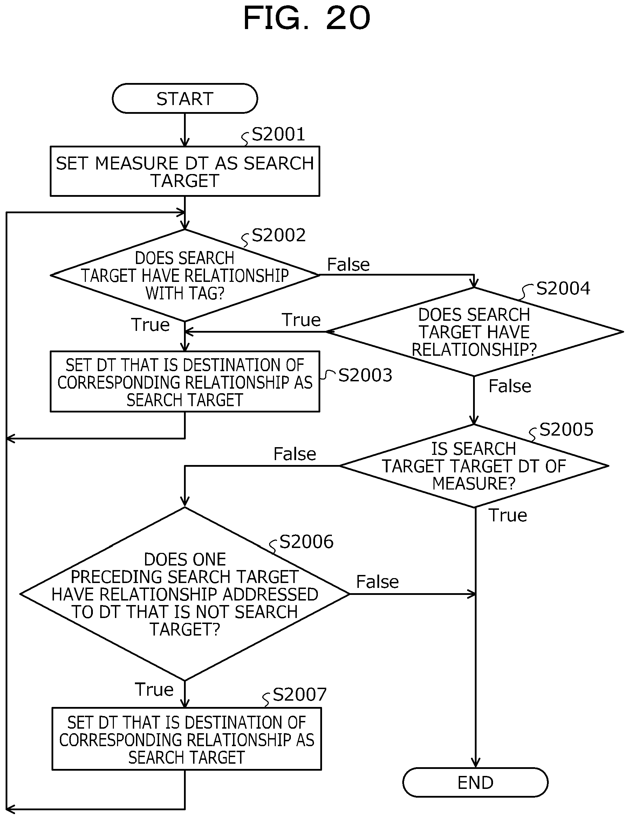

FIG. 20 is a flowchart illustrating a digital twin search processing example. The processing illustrated in FIG. 20 is executed by executing the program by the control unit (CPU 1301) of the digital twin search device 1220.

The digital twin search device 1220 sets a measure DT corresponding to a measure created by the user U as a search target (step S2001). Next, the digital twin search device 1220 determines whether or not the search target (DT) has the relationship R with the tag (step S2002).

If the search target (DT) has the relationship R with the tag (step S2002: True), the digital twin search device 1220 proceeds the processing to step S2003. On the other hand, if the search target (DT) does not have the relationship R with the tag (step S2002: False), the digital twin search device 1220 proceeds to processing in step S2004.

In step S2003, the digital twin search device 1220 sets a DT that is the destination of the corresponding relationship R as the search target (step S2003) and returns to the processing in step S2002.

In step S2004, the digital twin search device 1220 determines whether or not the search target (DT) has the relationship R (step S2004).

If the search target (DT) has the relationship R (step S2004: True), the digital twin search device 1220 proceeds to the processing in step S2003. On the other hand, if the search target (DT) does not have the relationship R (step S2004: False), the digital twin search device 1220 proceeds to processing in step S2005.

In step S2005, the digital twin search device 1220 determines whether or not the search target (DT) is a target DT of the measure (step S2005). If the search target (DT) is the target DT of the measure (step S2005: True), the digital twin search device 1220 ends the above processing. On the other hand, if the search target (DT) is not the target DT of the measure (step S2005: False), the digital twin search device 1220 proceeds to processing in step S2006.

In step S2006, the digital twin search device 1220 determines whether or not a one preceding search target has a relationship R addressed to a DT that is not the search target (step S2006). If the one preceding search target has the relationship R addressed to the DT that is not the search target (step S2006: True), the digital twin search device 1220 sets the DT that is the destination of the corresponding relationship R as a search target (step S2007). Then, the digital twin search device 1220 returns to the processing in step S2002. On the other hand, if the one preceding search target does not have the relationship R addressed to the DT that is not the search target (step S2006: False), the digital twin search device 1220 ends the above processing.

### (Another Application Example of Conversion into Cototwin According to Embodiment)

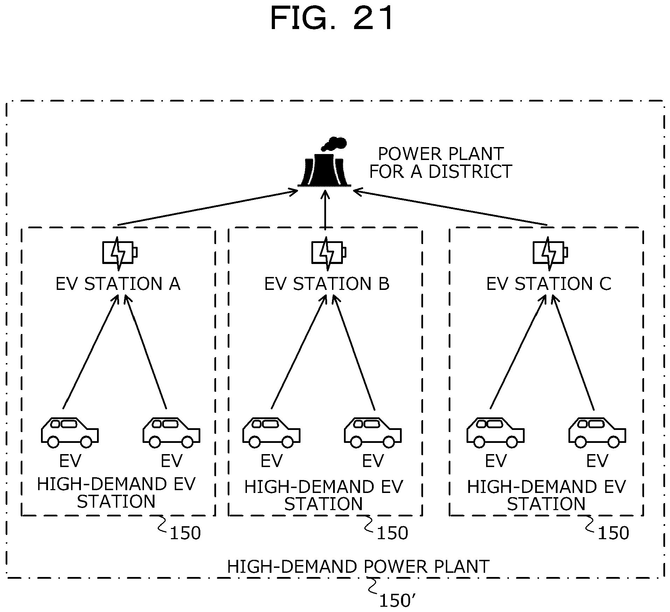

FIG. 21 is an explanatory diagram of another application example of conversion into cototwin according to the embodiment. In the example illustrated in FIG. 21, it is assumed that there be three EV stations A, B, and C, a plurality of EVs, and a power plant for an A district. The digital twin generation device 100 generates three cototwins 150 as high-demand EV stations, respectively for the EV stations A, B, and C.

In FIG. 21, multi-stage cototwin conversion having more stages is illustrated. The digital twin generation device 100 generates a high-demand power plant (cototwin 150') of the EV, by the three high-demand EV stations (cototwin 150) and the power plant for the A district having a relationship R with the three cototwins 150. The generated high-demand power plant (cototwin 150') includes a plurality of DTs including the power plant for the A district, the plurality of EV stations, and the plurality of EVs.

The digital twin generation device according to the embodiment can be applied to various applications for generating a digital twin of an object in the real world. For example, not limited to the road congestion, the power plant demand, or the like described above, the digital twin generation device can be applied to various digital twin systems generated based on a sensor value output from various devices such as an Internet of Things (IoT) device.

As described above, the digital twin generation device according to the embodiment aggregates a plurality of digital twins that can be aggregated and satisfies a specific condition, among the plurality of digital twins, and generates a single aggregated digital twin to which aggregation meaning is set. Then, a tag for identification is given to the generated aggregated digital twin. In this way, by generating the aggregated digital twin obtained by aggregating the plurality of digital twins, it is possible to shorten a search time at the time of search.

Furthermore, the digital twin generation device according to the embodiment may aggregate the plurality of digital twins having the same condition in the property, as a specific condition, in the generation processing. As a result, the aggregated digital twin is optimized by aggregating the plurality of digital twins having the same condition, and it is possible to shorten the search time at the time of search.

Furthermore, the digital twin generation device according to the embodiment may aggregate the plurality of digital twins having the same update time in the property, as a specific condition, in the generation processing. As a result, the aggregated digital twin is optimized by aggregating the plurality of digital twins having the same update time, and it is possible to shorten the search time at the time of search.

Furthermore, the digital twin generation device according to the embodiment may aggregate and set the properties of the plurality of digital twins that are aggregation sources, to the property of the aggregated digital twin, in the generation processing. As a result, the aggregated digital twin is optimized by aggregating the properties of the plurality of digital twins, and it is possible to shorten the search time at the time of search.

Furthermore, the digital twin generation device according to the embodiment may aggregate and set the relationship of each of the plurality of digital twins that is an aggregation source, to the relationship of the aggregated digital twin, in the generation processing. As a result, the aggregated digital twin reduces the number of plurality of relationships of the plurality of digital twins by aggregation, and it is possible to shorten the search time by the reduced number of relationships, at the time of search.

Furthermore, the digital twin generation device according to the embodiment may aggregate meaning of the property of each of the plurality of digital twins that is the aggregation source, as the aggregated meaning and may set the meaning to the property of the aggregated digital twin, in the generation processing. As a result, the aggregated digital twin is optimized by aggregation while remaining the meaning of the plurality of digital twins that are the aggregation sources in the property, and it is possible to shorten the search time at the time of search.

Furthermore, the digital twin generation device according to the embodiment may aggregate the plurality of aggregated digital twins that satisfies the specific condition, among the plurality of generated aggregated digital twins and generate a single aggregated digital twin to which aggregation meaning is set, in the generation processing. By such multi-stage conversion into the aggregated digital twin, the number of digital twins and the number of relationships can be reduced, and the search time can be further shortened.

Furthermore, the digital twin generation device may monitor a twin database that records and holds the digital twin and add and record the generated aggregated digital twin to the twin database, based on the detection of the plurality of digital twins that satisfies the specific condition, in the generation process. As a result, data of both of the aggregated digital twin and the digital twin before aggregation can be held, and for example, it is possible to generate the aggregated digital twin obtained by optimizing the digital twin, for each of search conditions corresponding to the different measures.

Note that a method related to the generation and the search of the digital twin described in the present embodiment can be achieved by executing a program prepared in advance on a computer such as a personal computer (PC) or a workstation. The digital twin generation and search program described in the present embodiment is executed by being recorded on a computer-readable recording medium and being read from the recording medium by the computer. Furthermore, the digital twin generation and search program described in the present embodiment may be distributed via a network such as the Internet.

## Claims

1. A method for generating a digital twin in which a computer executes processing comprising:
aggregating a plurality of digital twins that is aggregatable and satisfies a specific condition, from among a plurality of digital twins and generating a single aggregated digital twin to which aggregation meaning is set; and
giving a tag for identification to the generated aggregated digital twin.

2. The method according to claim 1, wherein
the generating processing
aggregates the plurality of digital twins that has the same condition in a property, as the specific condition.

3. The method according to claim 2, wherein
the generating processing
aggregates the plurality of digital twins that has the same update time in a property, as the specific condition.

4. The method according to claim 1, wherein
the generating processing
aggregates properties of the plurality of digital twins that is an aggregation source and sets the properties to a property of the aggregated digital twin.

5. The method according to claim 1, wherein
the generating processing
aggregates relationships of the plurality of digital twins that is an aggregation source and sets the relationships to a relationship of the aggregated digital twin.

6. The method according to claim 1, wherein
the generating processing
aggregates meaning of a property of each of the plurality of digital twins that is an aggregation source, as the aggregated meaning and sets the meaning to a property of the aggregated digital twin.

7. The method according to claim 1, wherein
the generating processing
aggregates a plurality of aggregated digital twins that satisfies a specific condition, among the plurality of generated aggregated digital twins and generates a single aggregated digital twin to which aggregation meaning is set.

8. The method according to claim 1, wherein
the generating processing
monitors a twin database that records and holds the digital twin, and
adds and records the generated aggregated digital twin to and in the twin database, based on detection of the plurality of digital twins that satisfies the specific condition.

9. A digital twin generation program for generating a digital twin in which a computer executes processing comprising:
aggregating a plurality of digital twins that is aggregatable and satisfies a specific condition, from among a plurality of digital twins and generating a single aggregated digital twin to which aggregation meaning is set; and
giving a tag for identification to the generated aggregated digital twin.

10. A digital twin search method for performing search of tracing a relationship of a plurality of digital twins that corresponds to a predetermined search condition, in which a computer executes processing comprising:
aggregating a plurality of aggregatable digital twins that satisfies a specific condition among the digital twins, determining whether or not a single aggregated digital twin exists generated by giving aggregated meaning, a relationship, and a tag for identification, based on whether or not there is the tag, and
preferentially performing search based on a relationship of the aggregated digital twin, in a case where the aggregated digital twin exists.
